Europäisches Patentamt

European Patent Office

Office européen des brevets

(11) Numéro de publication: **0 244 289**
A2

## (12) DEMANDE DE BREVET EUROPEEN

(21) Numéro de dépôt: **87400817.0**

(22) Date de dépôt: **10.04.87**

(51) Int. Cl.⁴: **H 01 J 37/30**
H 01 J 37/141

(30) Priorité: **15.04.86 FR 8605363**

(43) Date de publication de la demande:
**04.11.87 Bulletin 87/45**

(84) Etats contractants désignés: **DE GB NL**

(71) Demandeur: **THOMSON-CSF**
**173, Boulevard Haussmann**
**F-75379 Paris Cédex 08 (FR)**

(72) Inventeur: **Chambost, Emmanuel**
**THOMSON-CSF SCPI 19, avenue de Messine**
**F-75008 Paris (FR)**

(74) Mandataire: **Lepercque, Jean et al**
**THOMSON-CSF SCPI 19, avenue de Messine**
**F-75008 Paris (FR)**

(54) **Dispositif à faisceau électronique pour projeter l'image d'un objet sur un échantillon.**

(57) Le dispositif selon l'invention comprend deux étages de réduction à lentilles électromagnétiques ($L_2$, $L_3$).

Selon l'invention, il est prévu un tube isolant unique disposé entre un objet (S) et le plan échantillon (P), ce tube possédant une face intérieure métallisée.

Application à la microlithographie à faisceau électronique.

## Description

## DISPOSITIF A FAISCEAU ELECTRONIQUE POUR PROJETER L'IMAGE D'UN OBJET SUR UN ECHANTILLON

La présente invention se rapporte à un dispositif d'optique électronique pour projeter l'image d'un objet sur un échantillon.

La présente invention concerne plus particulièrement un système à faisceau de particules chargées conçu pour être utilisé dans la fabrication de configurations de circuits intégrés à grande échelle.

Il est courant d'utiliser des faisceaux à particules chargées, ions ou électrons, en technologie Planar de fabrication de composants ou circuits semiconducteurs pour impressionner des couches sensibles à ces particules en vue de réaliser des transformations physico-chimiques à travers les fenêtres qui sont dessinées sur les couches sensibles à l'action des faisceaux de particules. L'utilisation de ces faisceaux de particules chargées dans l'opération de dessin et gravure des couches sensibles, qu'on appelle microlithographie, est décrite, par exemple, dans le livre de E. MUNRO "Electron Beam Lithography in Applied Charged Particle Optics" - Septier Academic Press (1980).

Au plan de l'échantillon semi-conducteur, comme il est décrit dans cette publication, il est classique d'utiliser soit un faisceau dont la densité a une distribution géométrique Gaussienne, soit un faisceau aux contours définis, ou soit encore un faisceau aux contours définis mais que l'on peut faire varier selon l'exposition d'un échantillon semi-conducteur. La présente invention concerne les machines produisant des faisceaux des deux derniers types énoncés ci-dessus.

Un système à faisceau aux contours définis variables ("variable shaped beam" selon la terminologie anglo-saxonne) est notamment décrit dans la communication de J. TROTEL : "Electron Beam Direct Writing Lithographic System", publiée dans les "Proceedings on the 9th International Conference on Electron and Ion Beam Science and Technology".

Tous les systèmes de microlithographie électronique ou ionique comportent, pour adresser le faisceau sur un point donné de l'échantillon, à la fois un déplacement mécanique de la table sur laquelle est disposé l'échantillon et un déplacement du faisceau par des procédés magnétiques ou électrostatiques. Le déplacement de la table peut être mesuré avec une grande précision au moyen d'une interférométrie laser comme cela est décrit dans la demande de brevet français FR-A-2 220 073.

Lorsque le faisceau n'est pas défléchi par les moyens magnétique ou électrostatique, il est focalisé sur un plan dit Gaussien. Il est d'usage de situer le plan de l'échantillon au voisinage du plan Gaussien. Les moyens magnétiques pour défléchir le faisceau consistent généralement en des enroulements parcourus par un courant électrique agencés de diverses façons et les moyens électrostatiques consistent en des électrodes situées à proximité du parcours du faisceau. Lorsqu'on augmente la déflexion du faisceau, il apparaît dans le plan Gaussien, à la fois une défocalisation du faisceau et une non linéarité entre les signaux électriques excitant les déviateurs magnétiques ou électrostatiques et la distance défléchie du faisceau par rapport à l'axe. Ces défauts sont appelés aberrations géométriques et une description en est faite dans la publication de E. MUNRO précitée. L'ensemble des aberrations doit être inférieur à la précision recherchée.

Le problème de la minimisation de ces aberrations est décrit également dans cette publication.

Il est montré que l'on parvient à minimiser ces aberrations en distribuant la déflexion sur deux, trois étages ou même plus, chacun de ces étages ayant leur efficacité déterminée dans un rapport donné ainsi que leurs orientations azimutales respectives. On tire le maximum de tels arrangements lorsqu'un ou plusieurs de ces étages sont immergés, en partie ou totalement, dans le champ magnétique de la lentille.

Il est important de pouvoir opérer la variation de déflexion très rapidement, la stabilisation du faisceau devant se faire avec la précision requise par le système. Les limitations à cette rapidité sont plus importantes avec des déviateurs magnétiques à cause de l'effet de self et de l'apparition de courants de Foucault dans des pièces conductrices voisines des déviateurs. Il est courant de diviser le champ accessible au faisceau en zones ou "sous-champs", d'opérer des variations rapides à l'intérieur d'un sous-champ à l'aide d'un déviateur électrostatique et d'adresser le faisceau d'un sous-champ à un autre à l'aide d'un déviateur magnétique moins rapide, les courants de Foucault étant réduits au-dessous d'une limite acceptable en guidant les lignes de champ magnétique des déviateurs dans des pièces magnétiques non conductrices, par exemple des ferrites pour empêcher lesdites lignes de champ de circuler dans les pièces polaires des lentilles généralement conductrices. Pour minimiser l'apparition de courants de Foucault dans les pièces métalliques qui doivent entourer la trajectoire du faisceau, on doit réduire au maximum l'épaisseur de la couche conductrice, par exemple au moyen de techniques de couches minces sur tube isolant.

Un autre type d'aberration qui limite la résolution des systèmes de microlithographie par faisceau d'électrons provient d'effets coulombiens, c'est-à-dire de la répulsion entre électrons dans le faisceau. Cet effet devient important pour les faisceaux aux contours définis variables, parce qu'ils permettent de disposer sur l'échantillon un courant électronique de travail plus important. Il est démontré dans l'article "Transverse Coulombien Aberrations in electron lithography probes" paru dans "Optik 62", N° 2, page 189, 1982 que l'aberration $\delta_r$ dite de charge d'espace obéit à la relation :

$$\delta_r = \alpha - \frac{IL}{\alpha^2}$$

relation dans laquelle I désigne le courant de travail, L la trajectoire entre un diaphragme appelé stencil objet et le plan de l'échantillon et $\alpha$ la demi-ouverture du faisceau au plan de l'échantillon.

En outre, pour limiter au strict nécessaire les charges dans le faisceau, il est proposé dans la demande de brevet français FR-A-2 513 425 de disposer le diaphragme de limitation d'ouverture immédiatement en aval de la source de telle façon que ce diaphragme soit optiquement conjugué avec le centre optique de la dernière lentille.

En plus des limitations théoriques qui viennent d'être décrites, il existe également dans tout système de microlithographie des problèmes de contamination en fonction du temps d'utilisation qui provoquent une dérive du faisceau et une perte de résolution du système. Le nettoyage est une opération qui peut être longue et délicate.

La présente invention concerne un dispositif d'optique électronique permettant de projeter l'image réduite d'un objet sur un échantillon avec un facteur de réduction dont l'ordre de grandeur est typiquement de 1/50 pour une tension d'accélération typique de 20 kV.

Ce dispositif permet à un système de microlithographie d'être doté des propriétés typiques suivantes :
- résolution et précision meilleures que 0,1 $\mu$m, toutes aberrations confondues ;
- rapidité d'adressage du faisceau ;
- courant de travail sur l'échantillon supérieur à 4 $\mu$A ;
- diminution des risques de contamination, simplification du montage et du nettoyage, et
- champ magnétique nul ou négligeable au niveau de l'échantillon.

Pour ce faire, et en particulier pour obtenir une diminution des risques de contamination et une simplification du montage et du nettoyage, l'invention propose un dispositif dans lequel aucun déviateur électrostatique n'est utilisé et comportant un tube isolant métallisé unique couvrant le parcours du faisceau objet de l'échantillon. Il est proposé également un agencement des différents organes qui composent le dispositif de l'invention qui permette de réaliser les différentes exigences énoncées en maintenant la distance objet échantillons dans des limites raisonnables.

Ce qui distingue notamment l'invention des systèmes de l'Art Connu est de privilégier délibérément la réduction des aberrations coulombiennes en acceptant une réduction du champ adressé.

L'invention a donc pour objet un dispositif d'optique à faisceau électronique pour projeter l'image d'un objet sur un plan échantillon, comprenant deux étages de réductions à lentille électromagnétique pourvues de pièces de pièces polaires et d'axe optique déterminé, comportant un tube isolant unique à face intérieure métallisée protégeant la trajectoire du faisceau électronique entre l'objet et la pièce polaire inférieure de la dernière lentille.

L'invention sera mieux comprise et d'autres caractéristiques et avantages apparaîtront à la lecture de la description qui suit et de la figure unique annexée.

- La figure unique représente un dispositif selon l'invention.

La figure unique représente schématiquement un dispositif selon l'invention.

Le dispositif représenté sur la figure est en réalité une demi-coupe partielle d'un appareil de microlithographie, vue partielle limitée aux éléments essentiels de l'invention, c'est-à-dire la partie inférieure de l'appareil comprise entre un diaphragme S définissant le contour du faisceau de particules et un échantillon EC. Le faisceau non réfléchi a pour axe de symétrie l'axe optique $\Delta$ du dispositif.

Dans la suite, on appellera ce diaphragme S stencil l'objet. Dans le cas d'un système à faisceau aux contours définis variable, ce stencil S peut être un diaphragme comportant au moins deux arêtes formant un angle droit. L'image d'un autre stencil amont non représenté est également formée sur le même plan, comme il est bien connu.

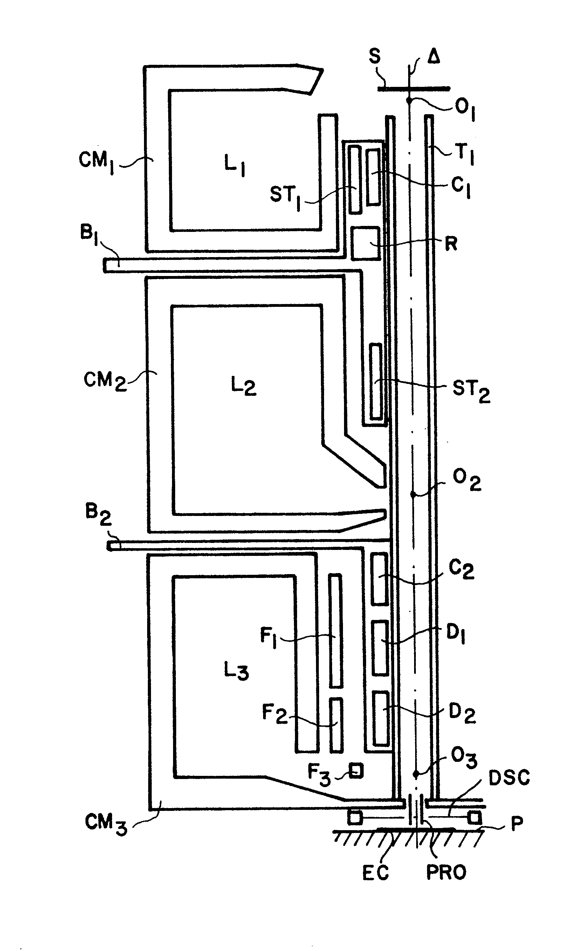

L'étage final représenté sur la figure 1 comporte trois étages, comprenant chacun une lentille électromagnétique : $L_1$ à $L_3$ pourvues de pièces polaires $CM_1$ à $CM_3$.

Les centres optiques des lentilles électromagnétiques sont respectivement $O_1$, $O_2$ et $O_3$.

La lentille électromagnétique $L_1$ est située matériellement en aval du stencil S, mais son centre optique $O_1$ est très proche du stencil (typiquement à moins de 10 mm). Le courant d'excitation de la lentille $L_1$ est réglé pour conjuguer, au centre optique $O_3$ de la lentille $L_3$, l'image d'un diaphragme de limitation d'ouverture, non représenté, situé dans la colonne électronique en amont du dispositif.

Pour fixer les idées, la lentille $L_2$ a son centre optique $O_2$ situé à 100 mm du stencil S. La dernière lentille $L_3$ a son centre optique $O_3$ situé à environ 65 mm du centre optique $O_2$. La distance entre $O_3$ et le plan de l'échantillon P est d'environ 20 mm.

Outre les lentilles $L_1$ à $L_3$, le dispositif comprend, au niveauu de la lentille $L_1$ :
un stigmateur magnétique $ST_1$ dont le rôle est de corriger l'orthogonalité du stencil S,
un déviateur statique magnétique $C_1$ destiné à centrer le faisceau dans la lentille $L_2$ et
une bobine coaxiale R excitée pour corriger l'orientation de l'image du stencil au plan de l'échantillon. La convergence de la bobine R est négligeable.

Le dispositif comprend en outre un stigmateur $ST_2$ destiné à corriger l'astigmatisme pris au sens classique du terme, c'est-à-dire une mise au point sur l'échantillon différente selon deux directions orthogonales considérées, au niveau de la lentille $L_2$ et
un déviateur dynamique $C_2$ destiné à centrer le faisceau dans la lentille $L_3$. Sur la figure 1, il a été représenté enfin deux éléments $D_1$ et $D_2$ qui sont les deux étages, mis en série, d'un déviateur dynamique destiné à adresser le faisceau sur le plan P de l'échantillon. Des éléments sont disposés au niveau de la lentille L$_3$.

Les éléments C$_1$-C$_2$ et D$_1$-D$_2$ sont chacun excités par deux courants indépendants permettant de régler la déviation du faisceau à la fois en amplitude et en rotation.

Les éléments C$_1$, ST$_1$, R et ST$_2$ peuvent être réunis dans un même bloc moulé B$_1$ dont les connexions de sortie seraient insérées entre les lentilles L$_1$ et L$_2$. De même, les éléments C$_2$, D$_1$ et D$_2$ peuvent être réunis dans un autre bloc moulé B$_2$ dont les connexions de sorties seraient insérées entre les lentilles L$_2$ et L$_3$.

Le dispositif comprend aussi les éléments F$_1$, F$_2$ et F$_3$ qui sont des pièces en matériau magnétique non conducteur, par exemple de la ferrite, destinées à guider les lignes de champ magnétique extérieures du déviateur D$_1$-D$_2$ et à éviter ainsi la génération de courants de Foucault dans des pièces conductrices.

Le rôle des deux dernières lentilles L$_2$ et L$_3$ est de réaliser une réduction de l'objet représenté par le stencil objet S dans un rapport typique de 1/20 à 1/100. La première lentille L$_1$ a pour rôle de régler, comme il a été précédemment indiqué, l'image du stencil S du centre optique O$_3$ de la troisième lentille L$_3$.

L'ensemble est complété par un détecteur semi-conducteur OSC situé entre la pièce polaire CM$_3$ de la dernière lentille L$_3$ et l'échantillon. Celui-ci est protégé par une pièce spéciale PRO entièrement métallique. Le rôle du détecteur DSC est de détecter les électrons secondaires émis par l'échantillon EC à des fins de réglage. Il possède une symétrie de révolution.

Selon une caractéristique principale de l'invention, il est prévu un tube T$_1$ unique entre l'objet S et l'échantillon EC. Ce tube est réalisé en matériau isolant et métallisé intérieurement pour permettre l'écoulement des charges électroniques. L'utilisation d'un tube unique entre objet et échantillon donne un avantage décisif par rapport aux machines de lithographie de l'Art Connu où sont disposés entre objet et échantillon des accessoires tels que plaques électrostatiques ou diaphragme de limitation d'ouverture.

La pièce spéciale PRO de protection du détecteur DSC a un diamètre plus petit que celui du tube T$_1$, mais le diamètre intérieur n'est en aucun cas percuté par les électrons quelle que soit la position adressée du faisceau. Le diamètre extérieur du tube unique T$_1$ est typiquement de 1 cm. Il peut être en alumine et la métallisation peut être effectué par un dépôt du type dit "electroless" comprenant une couche d'accrochage en cuivre et d'une couche de protection dorée.

Dans les conditions qui viennent d'être décrites, la distance totale entre objet (stencil S) et échantillon peut être réduite à moins de 20 cm pour une réduction de 1/50 avec une tension d'accélération des électrons de 20 kV.

## Revendications

1. Dispositif d'optique à faisceau électronique pour projeter l'image d'un objet (S) sur un plan échantillon (P), comprenant deux étages de réductions à lentille électromagnétique (L$_2$, L$_3$) pourvues de pièces polaires (CM$_1$ à CM$_3$) et d'axe optique déterminé (Δ), caractérisé en ce qu'il comporte un tube isolant unique (T$_1$) à face intérieure métallisée protégeant la trajectoire du faisceau électronique entre l'objet (S) et la pièce polaire inférieure (CM$_3$) de la dernière lentille (L$_3$).

2. Dispositif selon la revendication 1, caractérisé en ce qu'il comporte en outre entre l'objet (S) et la première lentille de réduction L$_2$, une lentille supplémentaire L$_1$, permettant de régler au centre optique (O$_3$) de la dernière lentille L$_3$ l'image d'un diaphragme de limitation situé en amont du plan objet (S).

3. Dispositif selon la revendication 2, caractérisé en ce que le dispositif comprend également un déviateur magnétique statique (C$_1$), un stigmateur (ST$_1$) et une bobine correctrice de rotation (R) au niveau de ladite lentille supplémentaire (L$_1$) ;un autre stigmateur (ST$_1$), au niveau de la première lentille de réduction (4), un déviateur magnétique statique (C$_2$) et un déviateur magnétique dynamique (D$_1$, D$_2$) au niveau de la lentille de réduction (L$_3$).

4. Dispositif selon la revendication 1, caractérisé en ce que le tube isolant unique (T$_1$) est un tube en alumine et que la métallisation est un dépôt métallique comprenant, superposées, une première couche en cuivre et une deuxième couche en or.

5. Dispositif selon l'une quelconque des revendications 1 à 4, caractérisé en ce qu'il est compris dans un appareil de microlithographie.

6. Dispositif selon la revendication 5, caractérisé en ce que l'appareil de microlithographie est à faisceau électronique à contours définis variables.

0244289